(19) Europäisches Patentamt
European Patent Office
Office européen des brevets

(11) EP 1 666 928 A1

(12) EUROPEAN PATENT APPLICATION
published in accordance with Art. 158(3) EPC

(43) Date of publication:
**07.06.2006 Bulletin 2006/23**

(21) Application number: **04787876.4**

(22) Date of filing: **10.09.2004**

(51) Int Cl.:
***G02B 5/30*** *(1968.09)*

(86) International application number:
**PCT/JP2004/013236**

(87) International publication number:
**WO 2005/026794 (24.03.2005 Gazette 2005/12)**

(84) Designated Contracting States:
**AT BE BG CH CY CZ DE DK EE ES FI FR GB GR HU IE IT LI LU MC NL PL PT RO SE SI SK TR**

(30) Priority: **12.09.2003 JP 2003321675**

(71) Applicant: **NITTO DENKO CORPORATION
Ibaraki-shi,
Osaka 567-8680 (JP)**

(72) Inventor: **SHUTOU, Shunsuke, c/o Nitto Denko Corp.
Ibaraki-shi, Osaka 567-8680 (JP)**

(74) Representative: **Vossius & Partner
Siebertstrasse 4
81675 München (DE)**

# (54) METHOD FOR PRODUCING ANISOTROPIC FILM

(57) A simple method for producing an anisotropic film, which does not require a light irradiation device having a special mechanism or an advanced alignment adjustment system, is provided. A film containing a photoreactive material is arranged on a polarizing element, and an anisotropy is provided to the film containing a photoreactive material by irradiating the film with light through a filter which blocks light having a wavelength of not more than 290 nm and through the polarizing element. With this method, an anisotropic film can be formed on the polarizing element.

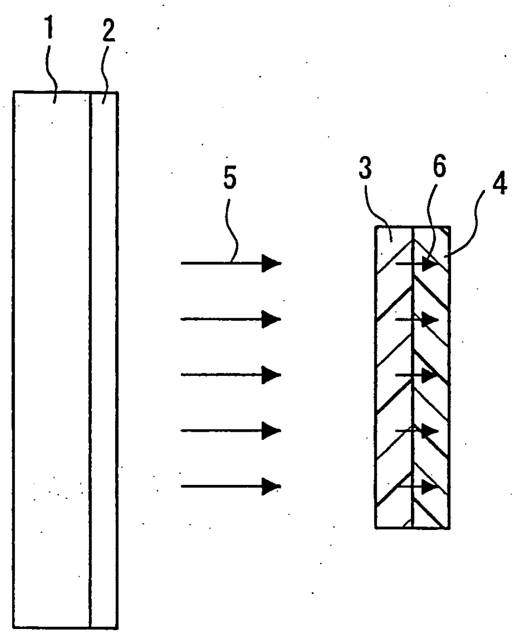


FIG. 1

EP 1 666 928 A1

## Description

### Technical Field

The present invention relates to a method for producing an anisotropic film.

### Background Art

Conventional methods for producing anisotropic films include, for example, a method of stretching a polymer film (uniaxially/biaxially), or a method of rubbing a film of polyimide, polyvinyl or the like. However, in the former method of stretching, it is difficult to control the condition for obtaining a desired anisotropy, and this may degrade accuracy in the anisotropy of the thus obtained film. In the latter treatment, rubbing may cause electrification in the film and generate dust.

For solving the above-mentioned problems, methods for producing anisotropic films, which do not require such stretching or rubbing, have been developed recently. Examples of the methods include a method for producing an anisotropic film by irradiating a photocrosslinkable polymer with polarized ultraviolet light so as to control a crosslinkage direction of the polymer (see non-patent documents 1 and 2, for example); a method for producing an anisotropic film by irradiating a photo-decomposable polymer with polarized ultraviolet light so as to control the direction of the decomposition of the intramolecular coupling in the polymer (see non-patent document 3 and patent document 1, for example); and a method for producing an anisotropic film by irradiating a photoisomerization polymer with polarized ultraviolet light so as to control the direction of isomerization of the polymer (see non-patent document 4, patent documents 2 and 3, for example).

However, any of these methods requires an ultraviolet irradiation device with a special mechanism for radiating polarized ultraviolet light. In addition to that, at the time of radiation of the polarized ultraviolet light, an advanced alignment adjustment for accurately adjusting the direction of the entering light with respect to the polymer film is required as well.

Patent document 1: JP H09(1997)-230353 A
Patent document 2: JP 2990270
Patent document 3: JP 3113539
Non-patent document 1: M. Schadt et al., Jpn.J.Appl.Phys., 31, p.2155-p.164 (1992)
Non-patent document 2: M. Schadt, Nature, 381, p.212, (1996)
Non-patent document 3: M. Nishikawa et al., Liquid Crystals, 26, p.575-580 (1992)
Non-patent document 4: Kunihiro Ichimura, "Applied Physics" vol.62, No. 10, p.998 (1993)

### Brief Description of Drawings

[FIG. 1] FIG. 1 is a schematic cross-sectional view showing light irradiation in one example of a manufacturing method according to the present invention.

### Disclosure of Invention

### Problem to be solved by the Invention

An object of the present invention is to provide a method for enabling the production of an anisotropic film in a simple manner without using any special devices.

### Means for Solving Problem

For achieving the object, a method for producing an anisotropic film according to the present invention is characterized by arranging a film containing a photoreactive material (hereinafter, referred to as "photoreactive material film") on a polarizing element and irradiating the photoreactive material film with light through a filter for blocking light having a wavelength of not more than 290 nm and through the polarizing element, thereby providing an anisotropy to the photoreactive material film.

### Effect of the Invention

As mentioned above, the production method of the present invention includes arranging a photoreactive material film on a polarizing element and irradiating the photoreactive material film with light through the polarizing element. Therefore, unlike in a conventional technique, any special devices are not required for the light irradiation device and a

general-purpose light irradiation device can be used. Moreover, by irradiating the polarizing element with light, an advanced alignment adjustment is not required, and thus an anisotropy with a preferred axial accuracy can be provided. Furthermore, since light is radiated through a filter (hereinafter referred to as 'a cutoff filter') to block light beams having a wavelength of not more than 290 nm for example, even a polarizing element, which will be degraded due to light having a wavelength of not more than 290 nm, can be used. That is, since light having a wavelength of not more than 290 nm is blocked by the cutoff filter, the polarizing element can be prevented from being degraded by the light passing through the cutoff filter. In this manner, a special device is not required, and degradation of the axial accuracy can be prevented by use of the polarizing element, and thus a large-area anisotropic film can be produced by using a large-area polarizing element. Moreover, since treatments such as stretching and rubbing are not required, unlike the conventional techniques, accuracy of the thus obtained anisotropy is improved and furthermore, dust can be suppressed.

Mode for Carrying Out the Invention

An example of the production method of the present invention will be described below, though the present invention is not limited thereto. First, a photoreactive material film is arranged on a polarizing element.

Though the polarizing element is not limited particularly, preferably for example, it can pass light having a wavelength in a range of 1 to 780 nm. As mentioned below, for light to be radiated on a photoreactive material film, a preferable range is 1 to 780 nm, and more preferably, a range of 200 to 400 nm, since in many cases the photoreactive material has an absorbing wavelength to be absorbed in an ultraviolet range.

Though there is no particular limitation on the polarizing element, a prism polarizer, a polarizing filter, and a polarizer can be used, for example. Examples of the prism polarizer include Glan-Thompsom prism, Glan-Laser prism, and Glan-Taylor prism, which include inorganic crystals of calcite or the like. Among them, a Glan-Taylor prism free of an adhesive layer is particularly preferred. For the polarizing filter; polarizing films or the like containing typical dichroic pigments can be used without any particular limitations.

For the polarizer, commonly-available products can be used without any particular limitations. It can be selected from films, prepared by being dyed by adsorbing a dichroic material such as iodine or a dichroic dye, followed by crosslinking, stretching and drying according to a known method, for example. Among them, films that can penetrate linearly-polarized light when natural light enters, more specifically, films having excellent light transmittance and polarization degree are preferable. Examples of the polymer film in which the dichroic material is to be adsorbed include hydrophilic polymer films such as polyvinyl alcohol (PVA)-based films, partially-formalized PVA-based films, partially-saponified films based on ethylene-vinyl acetate copolymer, and cellulose-based films. Other than the above, a polyene alignment film such as dehydrated PVA and dehydrochlorinated polyvinyl chloride can be used, for example. Among them, the PVA-based film is preferable. An example of the polarizer is described in JP 2000-162432 A. The polarizer is an ultraviolet polarizer containing an acicular material having an aspect ratio of at least 2 and a short diameter of 0.5 μm or less, the acicular material being dispersed in an ultraviolet transmitting film whose refractive index differs by at least 0.05 from that of the acicular material, while being aligned in a predetermined direction. This polarizer can be prepared, for example, by biaxially kneading 100 weight parts of polymethylpentene and 3 weight parts of needle titanium oxide being 0.1 μm at the short side and 10 μm at the long side, which is then shaped to a film 300 μm in thickness at 270°C by a T-die, and subsequently stretching 6 times its original length at 190°C.

In the production method of the present invention, it is preferable that the polarizing element is used for the polarizer. Since a large-area polarizing element is available, a large anisotropic film can be produced and supplied as mentioned above.

The thickness of the polarizing element is not limited particularly, but it is for example in a range of 1 to 1000 μm, preferably in a range of 5 to 500 μm, and more preferably in a range of 10 to 300 μm.

. The photoreactive material film can be formed directly on the polarizing element, or it can be arranged with interposition of additional layer(s) as mentioned below. When it is formed directly on the polarizing element, for example, a solution or melt of a photoreactive material is applied onto the polarizing element, which is then solidified.

For the photoreactive material, for example, any materials that can react with light having a wavelength in a range of 1 to 780 nm can be used. Specific examples include: materials to be isomerized by light, such as azobenzene, stilbene, spiropyran, anthracene and derivatives thereof; materials that are dimerized/polymerized by light, such as cinnamate derivatives like polyvinyl cinnamate, coumarin cinnamates, and chalcone cinnamates; photo-decomposable materials such as polyimide and polysiloxane; and a linear photopolymerization polymer or the like as represented by the following Formula (IV). These photoreactive materials can be used alone or can be mixed with at least one of the other materials.

[Formula 1]

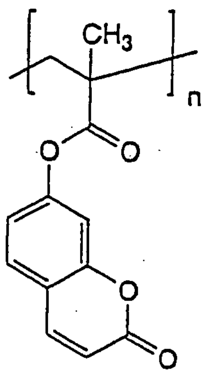

(IV)

The photoreactive material film can contain further a liquid crystalline compound as well as the photoreactive material. In this case, for example, the liquid crystalline material can be added further to the solution or melt of the photoreactive material. Examples of the liquid crystalline compounds include liquid crystalline monomers, liquid crystalline oligomers and liquid crystalline polymers. The liquid crystalline monomers exhibit themselves liquid crystalline properties and examples thereof include azomethines, azoxys, cyanobiphenyls, cyanophenyl esters, benzoates, cyclohexane carboxylic acid phenyl esters, cyanophenyl cyclohexanes, cyano-substituted phenylpyrimidines, alkoxy-substituted phenylpyrimidines, phenyldioxanes, tolans, and alkenylcyclohexylbenzonitriles. The liquid crystalline oligomers are not limited particularly, but an available example thereof is formed through polymerization of two to dozen or more of the above-mentioned liquid crystalline monomers, where the oligomer itself exhibits a liquid crystalline property. For the liquid crystalline polymers, conventionally-known polymers can be used without any particular limitations, but an available example is formed by polymerizing the liquid crystalline monomers to a higher degree than in the case of the liquid crystalline oligomer, where the polymer itself exhibits a liquid crystalline property. These liquid crystalline compounds can be used alone or can be mixed with at least one of the other liquid crystalline compounds. Examples of the mixture of two or more liquid crystalline compounds are described in JP 2000-517605 A, and specific examples of the available mixtures are shown in the following Formulae (I), (II) and (III).

[Formula 2]

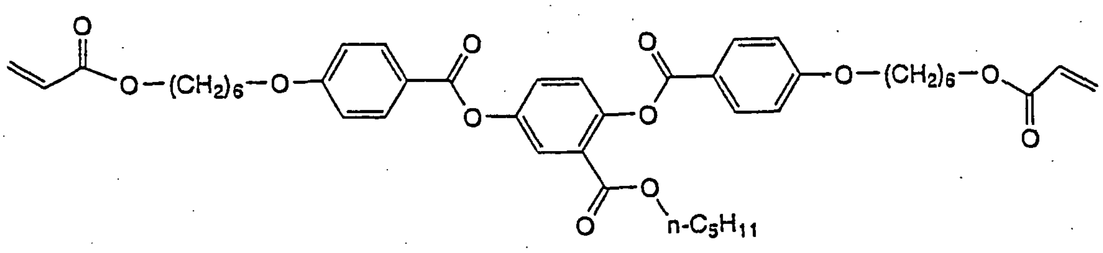

(I)

[Formula 3]

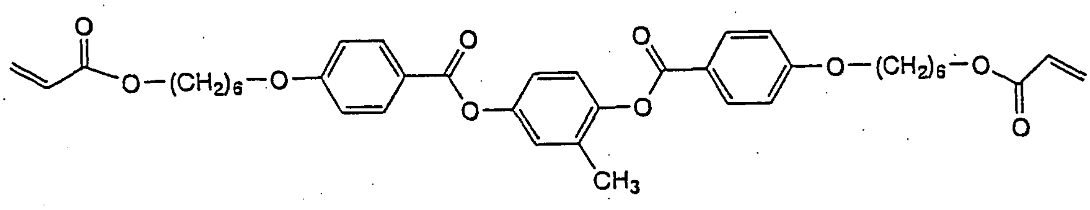

(II)

[Formula 4]

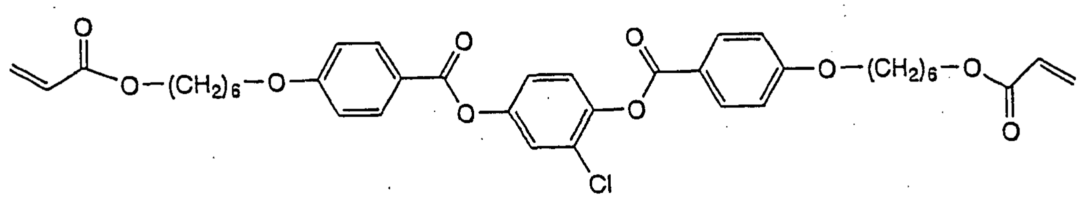

(III)

The photoreactive material film can contain the above-mentioned photoreactive material and further a non-liquid crystalline polymer. In this case, for example, the non-liquid crystalline polymer can be contained further in the solution/melt of the photoreactive material. Alternatively, the solution/melt can contain a monomer, an oligomer or the like for forming the non-liquid crystalline polymer by a subsequent polymerization, crosslinking or the like. This non-liquid crystalline polymer can be, for example, a non-liquid crystalline polymer formed from the above-mentioned liquid crystalline monomer and the liquid crystalline oligomer. In general, monomers or oligomers to form the non-liquid crystalline polymer exhibit a liquid crystalline property, but a polymer formed through polymerization of these monomers or oligomers exhibits not a liquid crystalline property but a non-liquid crystalline property. The non-liquid crystalline polymer can be used alone or it can be mixed with at least one of the other non-liquid crystalline polymers.

The photoreactive material can be, for example, a liquid crystalline monomer having a photoreactive site, a liquid crystalline oligomer having a photoreactive site, and a liquid crystalline polymer having a photoreactive site. Examples of the liquid crystalline monomer, liquid crystalline oligomer and liquid crystalline polymer are mentioned above.

The photoreactive site denotes a site that causes isomerization, decomposition, dimerization or polymerization due to light irradiation. Examples of such sites to cause isomerization due to light irradiation are azo, stilbene and the like. Examples of groups to cause dimerization or polymerization due to light irradiation include a vinyl group, a cinnamoyl group, a chalconyl group and the like. Examples of groups to cause decomposition due to light irradiation include imide groups and the like. These photoreactive materials can be used alone, or plural photoreactive materials can be used in combination.

When using a solution of the photoreactive material in formation of the photoreactive material film, the solution can be prepared by dissolving the photoreactive material in a solvent. The solvent can be selected without any particular limitations as long as it can dissolve the photoreactive material or the like, and the solvent can be determined suitably in accordance with the type of the photoreactive material. Specific examples thereof include halogenated hydrocarbons such as chloroform, dichloromethane, carbon tetrachloride, dichloroethane, tetrachloroethane, trichloroethylene, tetrachloroethylene, chlorobenzene and orthodichlorobenzene; phenols such as phenol and parachlorophenol; aromatic hydrocarbons such as benzene, toluene, xylene, methoxybenzene and 1,2-dimethoxybenzene; ketones such as acetone, methyl ethyl ketone, methyl isobutyl ketone, cyclohexanone, cyclopentanone, 2-pyrrolidone and N-methyl-2-pyrrolidone; esters such as ethyl acetate and butyl acetate; alcohols such as t-butyl alcohol, glycerin, ethylene glycol, triethylene glycol, ethylene glycol monomethyl ether, diethylene glycol dimethyl ether, propylene glycol, dipropylene glycol and 2-methyl-2,4-pentanediol; amides such as dimethylformamide and dimethylacetamide; nitriles such as acetonitrile and butyronitrile; ethers such as diethyl ether, dibutyl ether and tetrahydrofuran; or carbon disulfide, ethyl cellosolve or butyl cellosolve. These solvents may be used alone or in combination of two or more. And the solvents are preferred not to corrode the polarizing element.

The concentration of the photoreactive material in the photoreactive material solution is not limited particularly.

For providing a viscosity that facilitates the coating, the photoreactive material is preferred to be in a range of 0.1 to 30 wt% with respect to the solvent, preferably 0.5 to 15 wt%, and more preferably 1 to 5 wt%. When the concentration is 5 wt% or less, a viscosity for forming an extremely smooth coating surface can be obtained.

The above-mentioned photoreactive material solution or the melt (hereinafter, referred to as 'photoreactive material solution' for example) can contain the liquid crystalline compound or the non-liquid crystalline polymer as mentioned above.

The photoreactive material solution or the like can be blended further with various additives such as a stabilizer, a plasticizer, metals or the like as required.

When the photoreactive material includes the above-mentioned liquid crystalline monomers or the liquid crystalline oligomers which will be polymerized subsequently due to light irradiation, it is preferable that a photoinitiator is added further to the photoreactive material solution or the like. Though there is no particular limitation about the photoinitiator, for example, Irgacure907 (trade name), Irgacure369 (trade name), Irgacure 184 (trade name), which are supplied by Ciba Specialties Chemicals, or the mixture, is preferred. The amount of the photoinitiator to be added is not limited particularly as well.

Moreover, the photoreactive material solution or the like may contain other resins, for example. Such resins can be, for example, resins for general purpose use, engineering plastics, thermoplastic resins and thermosetting resins.

The resins for general purpose use can be, for example, polyethylene (PE), polypropylene (PP), polystyrene (PS), polymethyl methacrylate (PMMA), an ABS resin, an AS resin or the like. The engineering plastics can be, for example, polyacetate (POM), polycarbonate (PC), polyamide (PA: nylon), polyethylene terephthalate (PET), polybutylene terephthalate (PBT) or the like. The thermoplastic resins can be, for example, polyphenylene sulfide (PPS), polyethersulfone (PES), polyketone (PK), polyimide (PI), polycyclohexanedimethanol terephthalate (PCT), polyarylate (PAR), liquid crystal polymers (LCP) or the like. The thermosetting resins can be, for example, epoxy resins, phenolic resins, novolac resins or the like.

The method of coating the photoreactive material solution is not limited particularly but it is selected, for example, from spin coating, roller coating, flow coating, die coating, blade coating, printing, dip coating, flow-expanding, bar coating, gravure printing and extrusion.

The method for coating the melt of the photoreactive material is not limited particularly as long as the melt can be coated on a surface of the polarizing element. The examples include casting, melt-extrusion or the like.

The method of solidifying the photoreactive material solution is not limited particularly, but it is selected from drying methods such as natural drying and heat drying. The condition can be determined suitably without any particular limitations in accordance with, for example, the kinds of the materials of the polarizing element, the kinds of the photoreactive materials, and the kinds of the solvent. In general, the temperature for the process is preferred to be at a level that does not degrade the polarizing element, and specifically, it is preferred to be in a range of 0 to 150°C, and more preferably, 20 to 60°C.

Though there is no particular limitation, the photoreactive material film has a thickness in a range of 0.005 to 5 μm for example, preferably in a range of 0.01 to 0.5 μm, and more preferably in a range of 0.05 μm to 0.1 μm.

The photoreactive material film can be formed directly on a polarizing element as mentioned above. Alternatively, it can be arranged on the polarizing element by sticking or the like. The photoreactive material film can be prepared separately as mentioned above, or a commercially available product can be used.

When sticking the photoreactive material film onto the polarizing element, for example, an adhesive or an adhesive agent can be used. Examples of the adhesive include polymer adhesives based on acrylic substance, vinyl alcohol, silicone, polyester, polyurethane, and polyether; and rubber-based adhesives. The adhesive agents are prepared, for example, by including suitably as a base polymer, acrylic polymers, silicone-based polymers, polyester, polyurethane, polyether and synthetic rubbers. It is preferable that the adhesive or the adhesive agent has excellent optical transparency, and that will not hinder anisotropy to a photoreactive material film through light irradiation.

The photoreactive material film can be formed directly on the polarizing element as mentioned above. Alternatively, it can be arranged on the polarizing element through additional layer(s). When arranging the photoreactive material film on the polarizing element through additional layer(s), for example, the additional layer (for example, a protective layer as mentioned below) is formed on the polarizing element first, and a photoreactive material solution or the like is further coated thereon to form the photoreactive material film. Alternatively for example, it is possible to prepare the polarizing element, the additional layer and the photoreactive material film respectively and they are adhered through the above-mentioned adhesive or an adhesive agent in a certain order.

Though there is no particular limitation, the additional layer preferably transmits a light beam that can pass the polarizing element. For example, the layer can be used for a protective layer for the polarizing element. For the protective layer, conventionally-known transparent films can be used without any particular limitations. For example, the protective layer is preferred to have excellent transparency, mechanical strength, thermal stability, moisture proof, isotropism and the like. Specific examples of materials for the protective layers include cellulose-based resins such as triacetylcellulose (TAC), and transparent resins based on e.g., polyester, polycarbonate, polyamide, polyimide, polyethersulfone, polysulfone, polystyrene, polynorbornene, polyolefin, acrylic, acetate, and polyvinyl alcohol. Resins that will be cured by heat or ultraviolet rays, which are based on e.g., acrylic, urethane, acrylic urethane, epoxy, and silicone, can be used as well.

For the protective layer, for example, a polymer film that is described in JP2001-343529 A (WO01/37007) can be used as well. The polymer material can be, for example, a thermoplastic resin whose side chain has substituted/unsubstituted imide groups, and a thermoplastic resin whose side chain has substituted/unsubstituted phenyl groups and nitrile groups. An example thereof is a resin composition containing alternating copolymer containing isobutene and N-methyl maleimide and an acrylonitrile-styrene copolymer. The polymer film can be prepared by extruding the resin composition, for example.

It is preferable that the protective layers are colorless, for example. Specifically, it is preferable that a retardation value (Rth) of the film in the thickness direction as represented by the following equation is in a range of -90 nm to +75 nm. More preferably, it is from -80 nm to +60 nm, and particularly preferably from -70 nm to +45 nm. When the retardation value is in the range of -90 nm to +75 nm, coloring (optical coloring) due to the protective film can be solved sufficiently. In the equation below, nx, ny and nz respectively denote refractive indices of X-axis, Y-axis and Z-axis directions in the protective layer. The X-axis denotes an axial direction presenting a maximum refractive index within the protective layer, and the Y-axis denotes an axial direction perpendicular to the X-axis within the plane. The Z-axis denotes a thickness direction perpendicular to the X-axis and the Y-axis, and 'd' denotes a thickness of the protective layer.

$$Rth = [\{(nx + ny) / 2\} - nz] \cdot d$$

The protective layer further may have an optically-compensating function. As such a protective layer having the optically-compensating function, it is possible to use, for example, a known layer used for preventing coloration caused by changes in a visible angle based on retardation in a liquid crystal cell or for widening a preferable viewing angle. Specific examples include various films obtained by stretching the above-described resins uniaxially or biaxially, an aligned film of a liquid crystal polymer or the like, and a laminate obtained by providing an aligned layer of a liquid crystal polymer on a transparent base. Among the above, the aligned film of a liquid crystal polymer is preferable because a wide viewing angle with excellent visibility can be achieved. Particularly preferable is an optically-compensating retardation plate obtained by supporting an optically-compensating layer with the above-mentioned triacetylcellulose film or the like, where the optically-compensating layer is made of an incline-aligned layer of a discotic or nematic liquid crystal polymer. This optically-compensating retardation plate can be a commercially available product, for example, "WV film" (trade name) manufactured by Fuji Photo Film Co., Ltd. Alternatively, the optically-compensating retardation plate can be prepared by laminating two or more layers of the retardation film and the film support of triacetylcellulose film or the like so as to control the optical properties such as retardation.

The protective layer can be formed suitably by a conventionally known method such as a method of applying the above-mentioned various resins onto a polarizing film or a method of laminating the resin film, the optically-compensating retardation plate or the like on the polarizing film, or can be a commercially available product.

The thickness of the protective layer is not particularly limited. For example, the thickness is in the range not greater than 500 μm, preferably from 5 to 300 μm, and more preferably from 5 to 150 μm.

The protective layer further may be subjected to, for example, a hard-coating treatment, an antireflection treatment, treatments for anti-sticking, diffusion and anti-glare and the like. The hard-coating treatment aims at preventing scratches on the surfaces of the polarizing plate, and it is a treatment of, for example, providing a hardened coating film that is formed of a curable resin and has excellent hardness and smoothness onto a surface of the protective layer. The curable resin can be, for example, ultraviolet-curing resins of silicone base, urethane base, acrylic, and epoxy base. The treatment can be carried out by a conventionally known method. The anti-sticking treatment aims at preventing adjacent layers from sticking to each other. The antireflection treatment aims at preventing reflection of external light on the surface of the polarizing plate, and can be carried out by forming a conventionally known antireflection layer or the like.

When external light is reflected on the surface of the polarizing plate, the reflection will inhibit visibility of light transmitted through the polarizing plate. The anti-glare treatment aims at preventing such inhibition of visibility. The anti-glare treatment can be carried out, for example, by providing microscopic asperities on a surface of the protective layer by a conventionally known method. Such microscopic asperities can be provided, for example, by roughening the surface by sand-blasting or embossing, or by blending transparent fine particles in the above-described resin when forming the protective layer.

The above-described transparent fine particles may be silica, alumina, titania, zirconia, stannic oxide, indium oxide, cadmium oxide, antimony oxide or the like. Other than the above, inorganic fine particles having an electrical conductivity or organic fine particles comprising, for example, crosslinked or uncrosslinked polymer particles can be used as well. The average particle diameter of the transparent fine particles ranges, for example, from 0.5 to 20 μm, though there is no particular limitation. In general, a blend ratio of the transparent fine particles preferably ranges from

2 to 70 parts by weight, and more preferably ranges from 5 to 50 parts by weight with respect to 100 parts by weight of the above-described transparent resin, though there is no particular limitation.

The anti-glare layer in which the transparent fine particles are blended can be used as the protective layer itself or provided as a coating layer coated onto the protective layer-surface. Furthermore, the anti-glare layer also can function as a diffusion layer to diffuse light transmitted through the polarizing plate and thereby widen the viewing angle (i.e., visually-compensating function, for example).

The antireflection layer, the anti-sticking layer, the diffusion layer and the anti-glare layer mentioned above can be laminated on the polarizing element, as a sheet of optical layers comprising these layers, separately from the protective layer.

Next, light is radiated on a photoreactive material film arranged on the polarizing element, through a filter to block light having a wavelength of not more than 290 nm and also through the polarizing element.

An example of light irradiation is described below by using a cross sectional view of FIG. 1. As shown in FIG. 1, a photoreactive material film 4 is arranged on a surface of a polarizing element 3. A light irradiation device 1 having a cutoff filter 2 for blocking light beams having a wavelength of not more than 290 nm is used for irradiating the photoreactive material film 4 with a light beam 5 from the polarizing element 3 side. The light emitted from the light irradiation device passes through the polarizing element 3 while a light beam having a wavelength of not more than 290 nm is blocked by the cutoff filter, thereby forming polarized light 6. This polarized light 6 is radiated partially on the photoreactive material film 4, so that the photoreactive material film 4 changes the molecular structure at an irradiated part. In this manner, the molecular structure at the irradiated part becomes different from that at an unirradiated part, and thus the photoreactive material film 4 is provided with an anisotropy, thereby an anisotropic film is formed. This partial structural change is selected from isomerization, dimerization, polymerization, photo-decomposition or the like caused by light irradiation, in accordance with the kind of the above-mentioned photoreactive materials.

For a filter to block ultraviolet light having the wavelength of not more than 290 nm, conventionally-known filters such as a UV bandpass filter can be used. For example, when a polarizing film formed by adsorbing a typical dichroic material is used for the polarizing element, a filter for blocking ultraviolet light having a wavelength of not more than 290 nm can be used to prevent degradation of the polarizing film caused by the light of the wavelength.

The cutoff filter can be arranged between the light irradiation device and the polarizing element. It can be arranged on the light irradiation device or on a surface of the polarizing element.

The wavelength of the irradiated light is in a range of 1 to 780 nm, for example, preferably in a range of 200 to 400 nm, and more preferably in a range of 290 to 400 nm. The wavelength of the irradiated light can be selected suitably in accordance with the kind of the photoreactive material. For example, in a case where the photoreactive material is cinnamate, a range of 250 to 330 nm is preferred; for an azo-based material, a range of 380 to 450 nm is preferred; and for polyimide, a range of 1 to 300 nm is preferred. There is no particular limitation for the light irradiation device. For example, a commonly-used ultraviolet irradiation device can be used for radiating at a wavelength of 200 to 400 nm, and a commonly-used visible light irradiation device can be used for radiating light having a wavelength of 400 to 780 nm. It is preferable that the radiated light will have a wavelength within a range of light that can pass through the polarizing element.

The radiated light is polarized after passing through the polarizing element as mentioned above. In general, the types and degrees of this polarization differ depending on the kinds of the polarizing elements. Therefore, it is possible to select the type and degree of polarization in accordance with the kind of the polarizing element. In the present invention, due to polarization by the polarizing element, the photoreactive material in the photoreactive material film is decomposed, isomerized, dimerized or polymerized for example, and thus the molecules will be aligned in a predetermined form. In this manner, the film is provided with a refractive anisotropy.

In this manner, an anisotropic film is formed. The anisotropic film of the present invention can be used as a laminate with the polarizing element for example. Alternatively, it can be peeled off from the polarizing element and used alone.

Since the anisotropic film obtained by the production method of the present invention has an anisotropy for example, when a liquid crystal layer is formed on the film for example, the liquid crystal molecules can be aligned. For this reason, the anisotropic film can be used also for an alignment film such as a liquid crystal alignment film.

Alternatively, the anisotropic film of the present invention can be used as an optically anisotropic film. In particular, when the above-mentioned liquid crystalline compound or the non-liquid crystalline polymer are contained further in addition to the photoreactive material and when the photoreactive material is a liquid crystalline compound or a non-liquid crystalline polymer having a photoreactive site, the film will exhibit an optical anisotropy. Though the state of the optical anisotropy is not limited particularly, the optical anisotropy will be, for example, optical uniaxiality or optical biaxiality in accordance with the kinds of the liquid crystalline compound or the non-liquid crystalline polymer. The optical uniaxiality includes, in general, a negative uniaxiality where principal refractive indices nx and ny are substantially equal to each other and larger than nz ($nx \approx ny > nz$), and a positive uniaxiality where a principal refractive indices nx and ny are substantially equal to each other and smaller than nz ($nx \approx ny < nz$). The optical biaxiality denotes that the principal

refractive indices nx, ny and nz in three directions are different from each other, and it includes, for example, a negative biaxiality (nx > ny > nz) and a positive biaxiality (nz > nx > ny). The above-noted nx, ny and nz denote refractive indices of X-axis, Y-axis and Z-axis directions in the anisotropic film. The X-axis denotes an axial direction presenting a maximum refractive index within the anisotropic film, the Y-axis denotes an axial direction perpendicular to the X-axis within the plane, and the Z-axis denotes a thickness direction perpendicular to the X-axis and the Y-axis.

Next, the optical film of the present invention is characterized in that it includes an anisotropic film of the present invention. When the anisotropic film of the present invention exhibits an optical anisotropy as mentioned above, an optical film including the anisotropic film is useful for an optically-compensating film or a retardation plate.

The optical film of the present invention will not be limited particularly as long as it includes an anisotropic film of the present invention. Therefore, the anisotropic film of the present invention can be applied alone. Alternatively, it can be laminated with a polarizing element as mentioned above, or can include further additional optical element(s).

Conventionally-known various optical elements, which are used for image display devices such as liquid crystal displays, can be used for the additional optical element as mentioned above without any particular limitations. The examples include a polarizing plate, a reflector, a semitransparent reflector, and a brightness-enhancement film. These additional optical elements can be used alone or at least two kinds of optical elements can be used together. Such an optical element can form a single layer or a laminate of at least two layers. For the optical film further including additional optical element(s), for example, an integrated polarizing plate having an optically-compensating function is preferred. Such an integrated polarizing plate is suitably used for various image display devices. For example, it can be arranged on a surface of a liquid crystal cell.

Lamination of the anisotropic film of the present invention and an additional optical element can be carried out by a conventionally known process without any particular limitations. For example, an adhesive agent, an adhesive and the like as mentioned above can be used, and the kind can be determined suitably in accordance with the materials or the like of the respective components. The adhesives are made of polymers based on acrylic substances, vinyl alcohol, silicone, polyester, polyurethane and polyether, and rubber-based adhesives, for example. The adhesive can contain further a water-soluble crosslinking agent of a vinyl alcohol-based polymer such as boric acid, borax, glutaraldehyde, melamine and oxalic acid. Such an adhesive agent or adhesive can realize resistance to peeling under the influence of moisture or heat and excellent light transmittance and polarization degree. Specifically, when the additional optical element is a PVA-based film, for example, a PVA-based adhesive is used preferably from aspects of stability in an adhesion treatment or the like. Such an adhesive or an adhesive agent can be applied directly onto the surface of a polarizing element or a protective layer. Alternatively, a layer of the adhesive or the adhesive agent formed as a tape or a sheet can be arranged on the surface. When such an adhesive or an adhesive agent is prepared as a solution, other additive(s) or catalyst(s) such as acid(s) can be blended as required. When applying such an adhesive, for example, other additive(s) or catalyst(s) such as acid(s) can be blended in the adhesive solution. Though the thickness of the adhesive layer is not limited particularly, for example, it ranges from 1 nm to 500 nm, preferably from 10 nm to 300 nm, and more preferably from 20 nm to 100 nm. These adhesives can be used, for example, by coating an aqueous solution of the adhesive onto a surface of the respective component and drying. In the aqueous solution, for example, other additive(s) or catalyst(s) such as acid(s) can be blended. Among them, for the adhesive, a PVA-based adhesive is preferred in light of the excellent adhesiveness to the PVA film.

Next, as an example of the optical film of the present invention, a polarizing plate with an anisotropic film (integrated polarizing plate) will be explained below. The integrated polarizing plate is formed by laminating an anisotropic film of the present invention and a polarizing plate.

First, an example of a reflective polarizing plate or a semitransparent reflective polarizing plate will be described. The reflective polarizing plate is prepared by laminating further a reflector on a laminate of an anisotropic film of the present invention and a polarizing element (e.g., a polarizing plate), and the semitransparent reflective polarizing plate is prepared by laminating a semitransparent reflector on a polarizing plate of the present invention.

For example, such a reflective polarizing plate is arranged on a backside of a liquid crystal cell in order to make a liquid crystal display (reflective liquid crystal display) to reflect incident light from a visible side (display side). The reflective polarizing plate has some advantages, for example, assembling of light sources such as a backlight can be omitted, and the liquid crystal display can be thinned further.

The reflective polarizing plate can be formed in any known manner such as forming a reflector of metal or the like on one surface of a polarizing plate having a certain elastic modulus. More specifically, one example thereof is a reflective polarizing plate formed by matting one surface (surface to be exposed) of a protective layer of the polarizing plate as required, and providing the surface with a deposited film or a metal foil comprising a reflective metal such as aluminum.

An additional example of a reflective polarizing plate is prepared by forming, on a protective layer having a surface with microscopic asperities due to microparticles contained in various transparent resins, a reflector corresponding to the microscopic asperities. The reflector having a microscopic asperity surface diffuses incident light irregularly so that directivity and glare can be prevented and irregularity in color tones can be controlled. The reflector can be

formed by attaching the metal foil or the metal deposited film directly on an asperity surface of the transparent protective layer in any conventional and appropriate methods including deposition and plating such as vacuum deposition, ion plating and sputtering.

As mentioned above, the reflector can be formed directly on a protective layer of a polarizing plate. Alternatively, the reflector can be used as a reflecting sheet formed by providing a reflecting layer onto an appropriate film similar to the transparent protective film. Since a typical reflecting layer of a reflector is made of a metal, it is preferably used in a state such that the reflecting surface of the reflecting layer is covered with the film, a polarizing plate or the like in order to prevent a reduction of the reflection rate due to oxidation, and furthermore, the initial reflection rate is maintained for a long period, and a separate formation of a protective layer is avoided.

A semitransparent polarizing plate is provided by replacing the reflector in the above-mentioned reflective polarizing plate by a semitransparent reflector, and it is exemplified by a half-mirror that reflects and transmits light at the reflecting layer.

In general, such a semitransparent polarizing plate is arranged on a backside of a liquid crystal cell. In a liquid crystal display including the semitransparent polarizing plate, incident light from the visible side (display side) is reflected to display an image when a liquid crystal display is used in a relatively bright atmosphere, while in a relatively dark atmosphere, an image is displayed by using a built-in light source such as a backlight on the backside of the semitransparent polarizing plate. In other words, the semitransparent polarizing plate can be used to form a liquid crystal display that can save energy for a light source such as a backlight under a bright atmosphere, while a built-in light source can be used under a relatively dark atmosphere.

Next, as one example of an optical film of the present invention, a polarizing plate prepared by further laminating a brightness-enhancement film on an anisotropic film of the present invention and a polarizing element (e.g., a polarizing plate) will be explained below.

A suitable example of the brightness-enhancement film is not particularly limited, but it can be selected from a multilayer thin film of a dielectric or a multilayer lamination of thin films with varied refraction anisotropy that transmits linearly polarized light having a predetermined polarization axis while reflecting other light. Examples of such a brightness-enhancement film include trade name: "D-BEF" manufactured by 3M Co. Also a cholesteric liquid crystal layer, more specifically, an aligned film of a cholesteric liquid crystal polymer or an aligned liquid crystal layer fixed onto a supportive film base can be used as the brightness-enhancement film. Such a brightness-enhancement film reflects either clockwise or counterclockwise circularly polarized light while transmitting other light. Examples of such a brightness-enhancement film include trade name: "PCF 350" manufactured by Nitto Denko Corporation; trade name: "Transmax" manufactured by Merck and Co., Inc.

The above-mentioned optical film of the present invention can be, for example, an optical element formed by laminating an anisotropic film of the present invention and a polarizing element, and further at least two additional optical elements.

An optical member including a laminate of at least two optical elements can be formed, for example, by a method of laminating layers separately in a certain order for manufacturing a liquid crystal display or the like. However, efficiency in manufacturing a liquid crystal display can be improved by using an optical member that has been laminated previously because of its excellent stability in quality, assembling operability and the like. Any appropriate adhesives such as an adhesive agent layer can be used for lamination.

Moreover, it is preferable that the above-mentioned optical film of the present invention further has an adhesive agent layer or an adhesive layer so as to allow easier lamination onto the other members such as a liquid crystal cell. They can be arranged on one surface or both surfaces of the optical film. The material of the adhesive agent layer is not particularly limited but can be a conventionally known material such as acrylic polymers. Further, the adhesive agent layer having a low moisture absorption coefficient and an excellent thermal resistance is preferable from the aspects of prevention of foaming or peeling caused by moisture absorption, prevention of degradation in the optical properties and warping of a liquid crystal cell caused by difference in thermal expansion coefficients, and formation of a liquid crystal display with high quality and excellent durability. It is also possible to incorporate fine particles so as to form the adhesive agent layer showing light-diffusion property For the purpose of forming the adhesive agent layer on the surface of the optical film, a solution or melt of a sticking material can be applied directly on a predetermined surface of the polarizing plate with anisotropic film by a development method such as flow-expansion and coating. Alternatively, an adhesive agent layer can be formed on a separator, which will be described below, in the same manner and transferred to a predetermined surface of the optical film. Such a layer can be formed on any surface of the optical film. For example, it can be formed on an exposed surface of the anisotropic film.

When a surface of a layer of an adhesive agent or the like provided on the optical film is exposed, preferably, the adhesive agent layer is covered with a separator until the time the pressure-sensitive adhesive layer is used so that contamination or the like will be prevented. Preferably, the separator has a peeling coat on a surface to be brought into a contact with a surface of the adhesive agent layer. The peeling coat can be formed by applying onto the separator a peeling agent based on silicone, long-chain alkyl, fluorine, molybdenum sulfide or the like as required.

The adhesive agent layer or the like can be a monolayer or a laminate. The laminate can be a combination of monolayers different from each other in type or in composition. The adhesive agent layers arranged on both surfaces of the optical film can be the same or different from each other in type or in composition. The thickness of the adhesive agent layer can be determined appropriately depending on the constituents or the like of the optical film. In general, the thickness of the adhesive agent layer is 1 μm to 500 μm.

It is preferable that the adhesive agent layer is made of an adhesive agent having excellent optical transparency and sticking characteristics such as wettability, cohesiveness, and adhesiveness. As a specific example, the adhesive agent can be prepared appropriately based on polymers such as an acrylic polymer, a silicone-based polymer, polyester, polyurethane, polyether, and synthetic rubber.

Sticking characteristics of the adhesive agent layer can be controlled appropriately in a known manner. For example, the degree of cross-linkage and the molecular weight will be adjusted on the basis of a composition, molecular weight, crosslinking type, a content of the crosslinking functional group, and an amount of the blended crosslinking agent of the base polymer of the adhesive agent layer.

The respective layers composing the optical film of the present invention can have ultraviolet absorption power as a result of treatment with an ultraviolet absorbent such as a salicylate-based compound, a benzophenone-based compound, a benzotriazole-based compound, a cyanoacrylate-based compound, and a nickel complex salt-based compound.

As mentioned above, the optical films of the present invention can be used preferably for forming various devices such as liquid crystal displays. For example, an optical film of the present invention is arranged on at least one surface of a liquid crystal cell in order to form a liquid crystal panel used in a liquid crystal display of, e.g., a transmission type, a reflection type, or a transmission-reflection type.

The type of the liquid crystal cell for composing the liquid crystal display can be selected arbitrarily, and examples thereof include various cells such as an active matrix driving type represented by a thin film transistor, a simple matrix driving type represented by a TN (Twisted Nematic) cell and an STN (Super Twisted Nematic) cell, an OCB (Optically Compensated Birefringence) cell, a HAN (Hybrid Aligned Nematic) cell, and a VA (Vertical Aligned) cell.

In general, the liquid crystal cell is composed of opposing liquid crystal cell substrates and a liquid crystal injected into a space between the substrates. The liquid crystal cell substrates can be made of glass, plastics or the like without any particular limitations. Materials for the plastic substrates can be selected from conventionally known materials without any particular limitations.

When various optical members are arranged on both surfaces of a liquid crystal cell, they can be the same or different types. Moreover, for forming a liquid crystal display, one or more layers of appropriate members such as a prism array sheet, a lens array sheet, an optical diffuser and a backlight can be arranged at proper positions.

The liquid crystal display of the present invention is not particularly limited as long as it includes a liquid crystal panel having the above-mentioned optical film of the present invention. When it includes a light source, preferably, the light source is a flat light source emitting polarized light for enabling effective use of light energy, though there is no particular limitation.

For an example of a liquid crystal panel of the present invention, the following configuration can be referred to. For example, it has a liquid crystal cell, an optical film of the present invention (e.g., a laminate of an anisotropic film and a polarizing element), a polarizer and a protective layer, where the optical film is laminated on one surface of the liquid crystal cell, while the polarizer and the protective layer are laminated in this order on the other surface of the optical film. The liquid crystal cell has a configuration to hold a liquid crystal between two liquid crystal cell substrates. When the optical film is a laminate of an anisotropic film and a polarizing element as mentioned above, though the arrangement is not limited particularly, for example, the anisotropic film side faces preferably the liquid crystal cell.

The liquid crystal display of the present invention can include additionally on the visible side of the optical film, for example, a diffusion plate, an anti-glare layer, an antireflection film, a protective layer, and a protective plate. Alternatively, a compensating retardation plate or the like can be arranged suitably between the liquid crystal cell and the polarizing plate in the liquid crystal panel.

The optical film of the present invention can be used not only in the above-described liquid crystal display but also in, for example, self-light-emitting displays such as an organic electroluminescence (EL) display, a plasma display (PD) and a FED (Field Emission Display). When it is used in a self-light-emitting flat display, for example, the in-plane retardation values $\Delta nd$ of the optical film of the present invention are set to $\lambda/4$ in order to obtain circularly polarized light, and thus it can be used for an antireflection filter.

The following is a specific description of an electroluminescence (EL) display comprising the optical film of the present invention. The EL display of the present invention is a display having the optical film of the present invention, and can be either an organic EL display or an inorganic EL display

In recent EL displays, for preventing reflection from an electrode in a black state, use of an optical film such as a polarizer and a polarizing plate as well as a $\lambda/4$ plate is proposed. The optical film of the present invention is especially useful when linearly polarized light, circularly polarized light or elliptically polarized light is emitted from an EL

layer. The optical film of the present invention is especially useful when an oblique light beam is partially polarized even in the case where natural light is emitted in a front direction.

Now, a typical organic EL display will be explained below. In general, such an organic EL display has a luminant (organic EL luminant) that is prepared by laminating a transparent electrode, an organic luminant layer and a metal electrode in this order on a transparent substrate. Here, the organic luminant layer is a laminate of various organic thin films. Examples thereof include various combinations such as a laminate of a hole injection layer made of a triphenylamine derivative or the like and a luminant layer made of a fluorescent organic solid such as anthracene; a laminate of the luminant layer and an electron injection layer made of a perylene derivative or the like; and a laminate of the hole injection layer, the luminant layer and the electron injection layer.

In general, the organic EL display emits light according to the following principle: a voltage is applied to the anode and the cathode so as to inject holes and electrons into the organic luminant layer, energy generated by the re-bonding of these holes and electrons excites the fluorescent substance, and the excited fluorescent substance emits light when it returns to the basis state. The mechanism of the re-bonding of these holes and electrons during the process is similar to that of an ordinary diode. This implies that the current and the light emitting intensity show a considerable nonlinearity accompanied with a rectification with respect to the applied voltage.

It is required for the organic EL display that at least one of the electrodes is transparent so as to obtain luminescence at the organic luminant layer. In general, a transparent electrode of a transparent conductive material such as indium tin oxide (ITO) is used for the anode. Use of substances having small impedance for the cathode is effective for facilitating the electron injection and thereby raising luminous efficiency, and in general, metal electrodes such as Mg-Ag and Al-Li can be used.

In an organic EL display configured as described above, it is preferable that the organic luminant layer usually is made of a film that is extremely thin such as about 10 nm, so that the organic luminant layer can transmit substantially all light like the transparent electrode. As a result, when the layer does not illuminate, a light beam entering from the surface of the transparent substrate and passing through the transparent electrode and the organic luminant layer is reflected at the metal layer so that it comes out again to the surface of the transparent substrate. Thereby, the display surface of the organic EL display looks like a mirror when viewed from exterior.

For example, an organic EL display of the present invention, which includes the organic EL luminant, has a transparent electrode on the surface side of the organic luminant layer, and a metal electrode on the backside of the organic luminant layer. In the organic El display, it is preferable that an optical film of the present invention is arranged on the surface of the transparent electrode, and furthermore, a $\lambda/4$ plate is arranged between the polarizing plate and an EL element. As described above, an organic EL display obtained by arranging an optical film of the present invention can suppress external reflection and improve the visibility. It is further preferable that a retardation plate is arranged between the transparent electrode and the optical film.

For example, the optical film polarizes light which enters from outside and is reflected by the metal electrode, and thus the polarization has an effect that the mirror of the metal electrode cannot be viewed from the outside. Particularly, the mirror of the metal electrode can be blocked completely by forming the retardation plate with a quarter wavelength plate and adjusting an angle formed by the polarization directions of the retardation plate and the optical film (e.g., a laminate of an anisotropic film and a polarizing element) to be $\pi/4$. That is, the optical film transmits only the linearly polarized light component among the external light entering the organic EL display. In general, the linearly polarized light is changed into elliptically polarized light by the retardation plate. When the retardation plate is a quarter wavelength plate and when the angle is $\pi/4$, the light is changed into circularly polarized light.

This circularly polarized light passes through, for example, the transparent substrate, the transparent electrode, and the organic thin film. After being reflected by the metal electrode, the light passes again through the organic thin film, the transparent electrode and the transparent substrate, and turns into linearly polarized light at the retardation plate. Moreover, since the linearly polarized light crosses the polarization direction of the optical film at a right angle, it cannot pass through the optical film. Consequently, as described above, the mirror of the metal electrode can be blocked completely.

The following is a further description of the present invention by way of Examples and Comparative Examples. It should be noted that the present invention is not limited to these Examples alone.

Example 1

An acrylic hard-coating material (trade name: Unidek manufactured by Dainippon Ink Co. Ltd.) was dissolved in a toluene solvent to make a 20 wt% solution. This solution was coated on one surface of a commercially available polarizer by bar coating. The polarizer has a trade name of NPF manufactured by Nitto Denko Corporation, and is prepared by subjecting a PVA film to dyeing by adsorbing iodine, and then crosslinking, stretching and drying. The thus coated film was dried at 50°C for 1 minute so as to form an acrylic hard coat layer (protective layer) having a thickness of 1 $\mu$m on the polarizer.

A photoreactive material (trade name: LPPF301 manufactured by Vantico Co., Ltd.) was dissolved in a cyclopentanone solvent to make a 2 wt% solution. This solution was coated on the hard coat layer by spin coating. The thus coated film was dried at 90°C for 3 minutes so as to form a photoreactive material film having a thickness of 50 nm on the hard coat layer. A laminate obtained in this manner includes a photoreactive material film laminated on the polarizer with interposition of a hard coat layer.
On a surface of a quartz plate of an ultraviolet radiation device (which uses a high-pressure mercury lamp), a UV bandpass filter (trade name: WG295 manufactured by Shot Co., Ltd) was arranged for blocking a wavelength of not more than 290 nm. With this device, a light beam having a wavelength of 310 nm was radiated from the polarizer side of the laminate under a condition of illumination of 10 mW/cm$^2$ and an irradiation time of 3 minutes. Incidence angle of the light beam was set to an angle of 90° with respect to the polarizer. Thereby, a light beam which had passed through the UV bandpass filter and then had become polarized at the polarizer was radiated on the photoreactive material film, thereby an anisotropic film was formed on the polarizer through a hard coat layer. The accumulated quantity of light after passing through the polarizer was 0.5 J/cm$^2$.

Example 2

Polyvinyl alcohol (PVA) was dissolved in water to be 2 wt% so as to prepare a PVA aqueous solution. This solution was coated on one surface of a polarizer of the same type as in Example 1 by bar coating. The thus coated film was dried at 50°C for 1 minute, thereby forming a hard coat layer (protective layer) having a thickness of 50 μm.
A photoreactive material (polyvinyl cinnamate) was dissolved in a cyclopentanone solvent to make a 5 wt% solution. This polyvinyl cinnamate solution was coated on the hard coat layer by spin coating. The thus coated film was dried at 100°C for 2 minutes so as to form a polyvinyl cinnamate film (photoreactive material film) having a thickness of 50 nm. The thus obtained laminate had a photoreactive material film laminated on the polarizer with interposition of a hard coat layer.
On a surface of a quartz plate of an ultraviolet radiation device (which uses a high-pressure mercury lamp), a UV bandpass filter (trade name: WG295 manufactured by Shot Co., Ltd) was arranged for blocking a wavelength of not more than 290 nm. With this device, a light beam having a wavelength of 310 nm was radiated from the polarizer side of the laminate under a condition of illumination of 10 mW/cm$^2$ and an irradiation time of 6 minutes. Incidence angle of the light beam was set to an angle of 90° with respect to the polarizer. Thereby, an anisotropic film was formed on the polarizer with interposition of a hard coat layer. The accumulated quantity of light after passing through the polarizer was 1.0 J/cm$^2$.

Example 3

An acrylic hard-coating material (trade name: Unidek manufactured by Dainippon Ink Co. Ltd.) was dissolved in a toluene solvent to make a 20 wt% solution. This solution was coated on one surface of a commercially available polarizer by bar coating. The thus coated film was dried at 50°C for 1 minute so as to form an acrylic hard coat layer (protective layer) having a thickness of 1 μm.
A mixture of a liquid crystalline compound (68.0 wt%, trade name: LCPCB483 manufactured by Vantico Co., Ltd.), a photoreactive material (29.2 wt%, trade name: LPPF301 manufactured by Vantico Co., Ltd.), a photoinitiator (1.4 wt%, trade name: Irgacure369 manufactured by Ciba Specialty Chemicals) and an inhibitor (butyl hydroxytoluene, 1.4 wt%) was prepared. This mixture was dissolved in cyclopentanone to be 5 wt%, stirred at 50°C for 30 minutes, and subsequently passed through a 0.2-micron filter so as to prepare a coating solution.
This coating solution was applied on the hard-coating solution by spin coating. The thus coated film was dried at 100°C for 2 minutes so as to form a photoreactive material film having a thickness of 50 nm. The thus obtained laminate had a photoreactive material film laminated on the polarizer with interposition of a hard coat layer.
On a surface of a quartz plate of an ultraviolet radiation device (which uses a high-pressure mercury lamp), a UV bandpass filter (trade name: WG295 manufactured by Shot Co., Ltd) was arranged for blocking a wavelength of not more than 290 nm. With this device, a light beam having a wavelength of 310 nm was radiated from the polarizer side of the laminate under a condition of illumination of 10 mW/cm$^2$ and an irradiation time of 6 minutes. Incidence angle of the light beam was set to an angle of 90° with respect to the polarizer. Thereby, an anisotropic film was formed on the polarizer with interposition of a hard coat layer. The accumulated quantity of light after passing through the polarizer was 1.0 J/cm$^2$.

(Comparative Example 1)

A PVA film was laminated on a polarizer with interposition of a hard coat layer in the same manner as in Example 1 except that the photoreactive material was replaced by polyvinyl alcohol.

(Comparative Example 2)

A film was laminated on a polarizer in the same manner as Example 3 except that the photoreactive material was not added.

For the anisotropic films obtained in Examples 1-3, the anisotropies were evaluated in the following manner. Similarly, the films obtained in Comparative Examples 1 and 2 were evaluated.

Evaluation (1) for anisotropic film

A compound exhibiting a cholesteric liquid crystalline phase (a mixture of Paliocolor LC242 (trade name) and LC756 (trade name) manufactured by BASF) was dissolved in a cyclopentanone solvent at a rate of 20 wt%. This solution was applied by spin coating on a surface of an anisotropic film obtained in each Example. The thus coated film was heated at 90°C for 1 minute so as to align the compound exhibiting a cholesteric liquid crystalline phase, and then the compound was polymerized through light irradiation so as to fix the alignment, and thus a layer 1 μm in thickness (a layer exhibiting a cholesteric structure) was formed. Table 1 below indicates whether this layer has a selective reflection wavelength or not. In Table 1, 'Yes' in each of the left columns denotes that a selective reflection wavelength is observed and 'No' denotes that the selective reflection wavelength is not observed.

As shown in Table 1, the layers formed on the anisotropic films of Examples 1 and 2 exhibited selective reflection wavelengths. This shows that the anisotropic films of Examples 1 and 2 exhibited liquid crystal alignment power. On the other hand, since such a selective reflection was not observed for the film of Comparative Example 1, it is confirmed that the film formed on a polarizer did not exhibit a liquid crystal alignment power.

Evaluation of anisotropic film (2)

A compound exhibiting a nematic liquid crystalline phase (trade name: Paliocolor LC242 manufactured by BASF) was dissolved in a cyclopentanone solvent to make a 20 wt% solution, and this solution was applied by spin coating onto a surface of the anisotropic film obtained in an Example. Then, the thus coated film (compound layer) was heated at 90°C for 1 minute so as to align the compound exhibiting the nematic liquid crystalline phase, and further the compound was polymerized by light irradiation so as to fix the alignment, thereby forming a layer 1 μm in thickness (a layer exhibiting a nematic structure).

Furthermore, the thus formed layer was transferred onto a transparent base (glass plate). For the layer on the transparent base, the slow axis was measured by using a spectroscopic ellipsometer (trade name: M220 manufactured by JASCO Corporation). It was confirmed through the measurement that the polarization-transmission axis direction of the polarizer used in the Examples and either a slow axis or fast axis of each layer are equal to each other. On the other hand, the nematic liquid crystal was not aligned in the film of Comparative Example 1, but it became whitish to hinder detection of the axial angle. Similarly, the film of Comparative Example 2 became whitish to hinder detection of the axial angle.

Evaluation of anisotropic film (3)

The anisotropic film side of the film obtained in Example 3 was bonded to the transparent base (TAC film) with an adhesive and then the polarizer was peeled off to transfer the anisotropic film onto the transparent base. Then, the phase difference and the slow axis of the anisotropic film were measured with a spectroscopic ellipsometer (trade name: M220 manufactured by JASCO Corporation). It was confirmed through the measurement that the polarization-transmission axis direction of the polarizer used in Example 3 and a slow axis of the anisotropic film were equal to each other. The retardation value was about 100 nm (measurement wavelength was 590 nm). This result shows that the anisotropic film obtained in Example 3 exhibits an optical anisotropy.

(Table 1)

| | Selective reflection of cholesteric liquid crystal phase | Uniaxial alignment of nematic liquid crystal phase | Relative angle between polarization transmission axis and slow phase axis (degrees) | Retardation value (nm) |
|---|---|---|---|---|
| Example 1 | Yes | Good | 0 | - |
| Example 2 | Yes | Good | 90 | - |
| Example 3 | - | - | 0 | 100 |
| Com. Ex. 1 | No | Poor | Undetectable | - |

Table continued

| | Selective reflection of cholesteric liquid crystal phase | Uniaxial alignment of nematic liquid crystal phase | Relative angle between polarization transmission axis and slow phase axis (degrees) | Retardation value (nm) |
|---|---|---|---|---|
| Com. Ex. 2 | - | - | Undetectable | Undetectable |

It was confirmed from Table 1 that the anisotropic films of Examples 1 and 2 have liquid crystalline alignment power, the anisotropic film of Example 3 exhibits optical anisotropy and all the anisotropic films in the Examples have excellent axial accuracy

Industrial Applicability

As mentioned above, according to the production method of the present invention, for example, an anisotropic film with excellent axial accuracy can be produced easily, where either a special device for polarized light irradiation or an advanced alignment adjustment is not required. Furthermore, by use of a cutoff filter, for example, even a polarizing element that will be degraded by light having a wavelength of not more than 290 nm (especially a polarizing element formed of an organic material) can be used in a state with suppressed degradation.

## Claims

**1.** A method for producing an anisotropic film, the method comprising:

disposing a film containing a photoreactive material on a polarizing element;
irradiating the film containing the photoreactive material with light, through a filter that blocks light having a wavelength of not more than 290 nm and through the polarizing element so as to provide an anisotropy to the film containing the photoreactive material.

**2.** The production method according to claim 1, wherein the film containing the photoreactive material is formed by coating on the polarizing element a solution or a melt of a photoreactive material and by solidifying the solution or the melt.

**3.** The production method according to claim 1 or 2, wherein the photoreactive material has reactivity to light having a wavelength in a range of 1 nm to 780 nm.

**4.** The production method according to any of claims 1 to 3, wherein the wavelength of the radiated light is in a range of 200 nm to 400 nm.

**5.** The production method according to any of claims 1 to 4, wherein the wavelength of the radiated light is in a range of 290 nm to 400 nm.

**6.** The production method according to any of claims 1 to 5, wherein the wavelength of the radiated light is 310 nm.

**7.** The production method according to any of claims 1 to 6, wherein the polarizing element is at least one element selected from the group consisting of a prism polarizer, a polarizing filter and a polarizer.

**8.** The production method according to any of claims 1 to 7, wherein the film containing the photoreactive material is formed directly on the polarizing element.

**9.** The production method according to any of claims 1 to 7, wherein the film containing the photoreactive material is formed on the polarizing element with interposition of a protective layer.

**10.** The production method according to any of claims 1 to 9, wherein the film containing the photoreactive material further contains a liquid crystalline compound.

**11.** The production method according to claim 10, wherein the liquid crystalline compound is at least one liquid crystalline compound selected from the group consisting of a liquid crystalline monomer, a liquid crystalline oligomer and a liquid crystalline polymer.

**12.** The production method according to any of claims 1 to 11, wherein the film containing the photoreactive material further contains a non-liquid crystalline polymer.

**13.** The production method according to any of claims 1 to 12, wherein the photoreactive material is at least one material selected from the group consisting of a liquid crystalline monomer having a photoreactive site, a liquid crystalline oligomer having a photoreactive site, and a liquid crystalline polymer having a photoreactive site.

**14.** An anisotropic film produced by any of the production methods according to claims 1 to 13.

**15.** The anisotropic film according to claim 14, which comprises a liquid crystalline alignment film.

**16.** The anisotropic film according to claim 14, which comprises an optically anisotropic film.

**17.** An optical film comprising the anisotropic film according to claim 14.

**18.** A liquid crystal panel comprising a liquid crystal cell and an optical film arranged on at least one surface of the liquid crystal cell, wherein the optical film is the optical film according to claim 17.

**19.** A liquid crystal display comprising a liquid crystal panel, wherein the liquid crystal panel is the liquid crystal panel according to claim 18.

**20.** An image display device comprising the optical film according to claim 17.

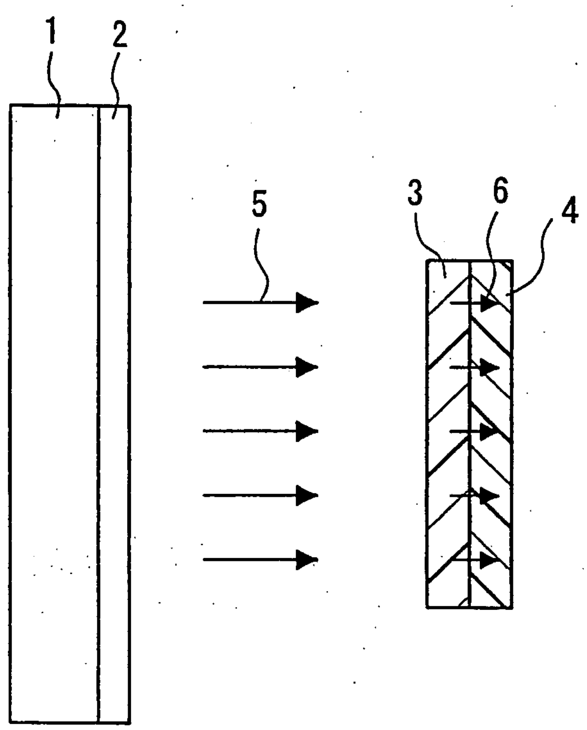


FIG. 1

**INTERNATIONAL SEARCH REPORT**

International application No.
PCT/JP2004/013236

A. CLASSIFICATION OF SUBJECT MATTER
Int.Cl$^7$ G02B5/30

According to International Patent Classification (IPC) or to both national classification and IPC

B. FIELDS SEARCHED

Minimum documentation searched (classification system followed by classification symbols)
Int.Cl$^7$ G02B5/30

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2002-202408 A (Hayashi Telempu Co., Ltd.), 19 July, 2002 (19.07.02), Full text; all drawings (Family: none) | 14-20<br>1-13 |
| A | JP 2002-202406 A (Hayashi Telempu Co., Ltd.), 19 July, 2002 (19.07.02), Full text; all drawings (Family: none) | 1-20 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 08 December, 2004 (08.12.04) | 21 December, 2004 (21.12.04) |
| Name and mailing address of the ISA/<br>Japanese Patent Office | Authorized officer |
| Facsimile No. | Telephone No. |

Form PCT/ISA/210 (second sheet) (January 2004)